# EUROPEAN PATENT APPLICATION

(11) **EP 2 199 353 A1**
(43) Date of publication of application: **23.06.2010**
(21) Application number: 09155070.7
(22) Date of filing: 13.03.2009
(51) Int. Cl.: C09G 1/02, C09K 3/14, H01L 21/321

(54) **Polymeric barrier removal polishing slurry**

(30) Priority: 22.12.2008 US 317550
(71) Applicant: Rohm and Haas Electronic Materials CMP Holdings, Inc., Wilmington, DE 19899 (US)
(72) Inventor: BIAN, Jinru, Newark, DE 19702 (US); YE, Qianqiu, Newark, DE 19702 (US)
(74) Representative: Kent, Venetia Katherine

(57) **Abstract**

The aqueous slurry is useful for chemical mechanical polishing semiconductor substrates having copper interconnects. The slurry includes by weight percent, 0 to 25 oxidizing agent, 1 to 50 abrasive particles, 0.001 to 10 inhibitor for decreasing static etch of the copper interconnects, 0.001 to 5 poly (methyl vinyl ether) having a formula as follows: 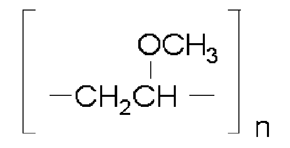 and the poly (methyl vinyl ether) is water soluble and n has a value of at least 5, 0 to 10 copper complexing agent formed during polishing and balance water.

## Description

### BACKGROUND OF THE INVENTION

As ultra-large-scale-integrated circuit (ULSI) technology migrates to smaller lines widths, there are new challenges for the integration of conventional chemical mechanical polishing (CMP) processes. In addition, the introduction of low k and ultra-low k dielectric films requires the use of a gentler CMP processes due to the films' low mechanical strength and weak adhesion to adjacent layers. Furthermore, ever-tightening defectivity specifications have placed additional demands on polishing slurries for low k films.

The integration of various low k films into USLIs can also require numerous extra steps and the incorporation of new technologies such as supercritical cleaning, dielectric and metal caps, conformal deposition of barriers and copper, chemical mechanical planarization with low down force and abrasive-free slurries. In addition to these technical options, ULSI fabricators must consider and address process complexity versus yield, reliability, mechanical strength, and performance, namely power dissipation from resistance-capacitance (RC) delay.

The complexities surrounding implementation of low k materials have introduced larger challenges for the barrier CMP process, which will necessitate the ability to control the complicated input variables and achieve a consistent high yield. Tuning process variables can contribute to decreasing polishing variation on the low k film. But the most desirable barrier CMP slurry will incorporate a low k dielectric-specific, surface activated agent that has process tunable performance adjustability. For example, Thomas et al. in US Pat. No. 6,916,742 disclose a slurry that adjusts the amount of polyvinyl pyrrolidone and phosphate to control tantalum nitride, copper and carbon doped oxide (CDO) removal rates. Adjusting the amounts of polyvinyl pyrrolidone and silica controls the ratio of tantalum nitride (barrier) to CDO (ultra low k dielectric) removal rates achieved with the slurry. Unfortunately, these slurries have inadequate barrier removal rate for some applications.

There is a demand for a polishing slurry that can achieve the modular removal of barriers to ultra low k dielectrics without excessive copper removal rates.
Furthermore, there is a demand for a slurry that can remove a barrier with controlled low k dielectric erosion.

### STATEMENT OF THE INVENTION

An aspect of the invention provides an aqueous slurry useful for chemical mechanical polishing a semiconductor substrate having copper interconnects comprising by weight percent, 0 to 25 oxidizing agent, 1 to 50 abrasive particles, 0.001 to 10 inhibitor for decreasing static etch of the copper interconnects, 0.001 to 5 poly (methyl vinyl ether) having a formula as follows: 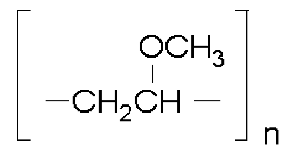 and the poly (methyl vinyl ether) is water soluble and n has a value of at least 5, 0 to 10 copper complexing agent formed during polishing and balance water.

Another aspect of the invention provides an aqueous slurry useful for chemical mechanical polishing a semiconductor substrate having copper interconnects comprising by weight percent, 0 to 20 oxidizing agent, 5 to 50 abrasive particles, 0.005 to 10 inhibitor for decreasing static etch of the copper interconnects, 0.005 to 5 poly (methyl vinyl ether) having a formula as follows: 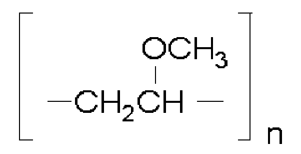 and the poly (methyl vinyl ether) is water soluble and n has a value of at least 10, 0 to 10 copper complexing agent formed during polishing and balance water; and the aqueous slurry having a pH of at least 8.

Another aspect of the invention provides a method of polishing a semiconductor substrate, the semiconductor substrate having a barrier layer, a TEOS layer and a low k dielectric layer, the method including the steps of: introducing polishing slurry onto a polishing pad, the polishing slurry having the composition comprising by weight percent, 0 to 25 oxidizing agent, 1 to 50 abrasive particles, 0.001 to 10 inhibitor for decreasing static etch of the copper interconnects, 0.001 to 5 poly (methyl vinyl ether) having a formula as follows: 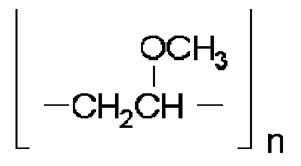 and the poly (methyl vinyl ether) is water soluble and n has a value of at least 5, 0 to 10 copper complexing agent formed during polishing and balance water; pressing the semiconductor substrate against the polishing pad; and creating motion between the polishing pad and the semiconductor substrate to remove the barrier layer with a selectivity to a carbon-doped oxide layer rate of at least 1 to 1 for removal rate measured in Angstroms per minute.

### DETAILED DESCRIPTION

It has been discovered that adding poly (methyl vinyl ether) to a copper barrier slurry can decrease carbon-doped oxide removal rate without an adverse impact upon the copper removal rate of semiconductor substrates. For purposes of this specification, semiconductor substrates include wafers having metal conductor interconnects and dielectric materials separated by insulator layers in a manner that can produce specific electrical signals. Furthermore, these slurries allow an increase in abrasive content to further increase the barrier removal rate without a negative impact on low k or copper removal rates. Finally, these slurries provide a platform for adjusting barrier, copper and dielectric removal rates to satisfy a variety of demanding semiconductor applications.

It has been discovered that water soluble poly (methyl vinyl ether) has a strong impact on decreasing removal rate of low k dielectrics, such as carbon-doped oxide. The poly (methyl vinyl ether) has a formula as follows:

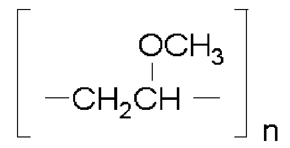

The n has a value of at least 5, preferably at least 10 and most preferably at least 20. If n is too high, then the poly (methyl vinyl ether) loses its water solubility. In addition, since copolymer formulations can have adverse polishing consequences, it is important that the poly (methyl vinyl ether) polymer only contain incidental impurities.
The poly (methyl vinyl ether) can be effective at concentrations between 0.001 and 5 weight percent. This specification expresses all concentrations in weight percent, unless specifically noted otherwise. Advantageously, the slurry has a poly (methyl vinyl ether) concentration between 0.005 and 5 weight percent. Most advantageously, the slurry has a poly (methyl vinyl ether) concentration between 0.01 and 1 weight percent.

The slurry also optionally contains 0 to 3 weight percent polyvinyl pyrrolidone for removal of barrier with selective removal rates of low k dielectric films. Optionally, the slurry contains 0 to 2 weight percent polyvinyl pyrrolidone. For example, the slurry optionally contains 0.01 to 1.5 weight percent polyvinyl pyrrolidone. For applications demanding barrier removal with a modest low k removal rate, the slurry preferably contains less than 0.4 weight percent polyvinyl pyrrolidone. For applications demanding barrier removal with a low low k removal rate, the slurry preferably contains at least 0.4 weight percent polyvinyl pyrrolidone. This non-ionic polymer facilitates polishing low k and ultra low k dielectric films (typically, hydrophobic) and hard mask capping layer films.

The polyvinyl pyrrolidone preferably has a weight average molecular weight of 1,000 to 1,000,000. For purposes of this specification, weight average molecular weight refers to molecular weight measured by gel permeation chromatography. The slurry more preferably has a molecular weight of 1,000 to 500,000 and most preferably a molecular weight of 2,500 to 50,000. For example, polyvinyl pyrrolidone having a molecular weight ranging from 12,000 to 15,000 has proven particularly effective.

The slurry optionally contains 0 to 5 phosphorus-containing compound. For purposes of this specification, a "phosphorus-containing" compound is any compound containing a phosphorus atom. Optionally, the slurry contains 0 to 3 phosphorus-containing compound. For example, the slurry optionally contains 0.01 to 2 phosphorus-containing compound. For example, phosphorus-containing compounds include phosphates, pyrophosphates, polyphosphates, phosphonates, phosphine oxides, phosphine sulphides, phosphorinanes, phosphonates, phosphites and phosphinates including, their acids, salts, mixed acid salts, esters, partial esters, mixed esters, and mixtures thereof, such as, phosphoric acid. In particular, the polishing slurry may include specific phosphorus-containing compounds as follows: zinc phosphate, zinc pyrophosphate, zinc polyphosphate, zinc phosphonate, ammonium phosphate, ammonium pyrophosphate, ammonium polyphosphate, ammonium phosphonate, diammonium phosphate, diammonium pyrophosphate, diammonium polyphosphate, diammonium phosphonate, potassium phosphate, dipotassium phosphate, guanidine phosphate, guanidine pyrophosphate, guanidine polyphosphate, guanidine phosphonate, iron phosphate, iron pyrophosphate, iron polyphosphate, iron phosphonate, cerium phosphate, cerium pyrophosphate, cerium polyphosphate, cerium phosphonate, ethylenediamine phosphate, piperazine phosphate, piperazine pyrophosphate, piperazine phosphonate, melamine phosphate, dimelamine phosphate, melamine pyrophosphate, melamine polyphosphate, melamine phosphonate, melam phosphate, melam pyrophosphate, melam polyphosphate, melam phosphonate, melem phosphate, melem pyrophosphate, melem polyphosphate, melem phosphonate, dicyanodiamide phosphate, urea phosphate, including, their acids, salts, mixed acid salts, esters, partial esters, mixed esters, and mixtures thereof.

The preferable phosphorus-containing compounds include ammonium phosphate and phosphoric acid. Excessive ammonium phosphate, however, can introduce excessive amounts of free ammonium into solution. And excessive free ammonium can attack the copper to produce a rough metal surface. Adding phosphoric acid reacts with free alkali metals in situ, such as potassium to form potassium phosphate salt and dipotassium phosphate salt that are particularly effective.

The potassium compound also provides the benefit of forming a protective film that protects copper in aggressive post-CMP cleaning solutions. For example, the post-CMP wafer's film has sufficient integrity to protect the wafer in pH 12 solutions having aggressive copper complexing agents such as, tetramethylammonium hydroxide, ethanolamine and ascorbic acid.

Optional tantalum barrier removal agent may be acetamidine, acetamidine salts, acetamidine derivatives, arginine, arginine salts, arginine derivatives, formamidine, formamidine salts, formamidine derivatives, guanidine, guanidine derivatives, guanidine salts and mixtures thereof. For example, the solution optionally relies upon at least one tantalum barrier removal agent selected from the group comprising formamidine, formamidine derivatives, formamidine salts, guanidine, guanidine derivatives and guanidine salts and mixture thereof to increase barrier removal rate. Specific examples include at least one of guanidine, guanidine hydrochloride, guanidine sulfate, aminoguanidine hydrochloride, guanidine acetic acid, guanidine carbonate, guanidine nitrate, formamidine, formamidine sulfinic acid, formamidine acetate and mixtures thereof. Optionally, the solution contains 0 to 12 weight percent barrier removal agent. In another alternative, the solution optionally contains 0 to 10 weight percent barrier removal agent; and for some formulations, optional barrier removal agent concentrations of 0.1 to 5 or 0.1 to 3 weight percent may increase barrier removal rates. These barrier removal agents have greater impact with formulations having lower solids concentration. Furthermore, depending upon pH level, increasing oxidizer addition such as hydrogen peroxide may further increase the impact of the barrier removal rate. For example, increasing hydrogen peroxide concentration can increase the effectiveness of barrier removal agents, such as formamidine and guanidine at acidic pH levels.

Oxidizing agent in an optional amount of 0 to 25 weight percent can facilitate removal of barrier layers, such as tantalum, tantalum nitride, titanium and titanium nitride. Optionally, the slurry contains 0 to 20 weight percent oxidizing agent. Most preferably, the slurry contains 0.05 to 10 weight percent oxidizing agent. Suitable oxidizers include, for example, hydrogen peroxide, monopersulfates, iodates, magnesium perphthalate, peracetic acid and other peracids, persulfates, bromates, periodates, nitrates, iron salts, cerium salts, manganese (Mn) (III), Mn (IV) and Mn (VI) salts, silver salts, copper salts, chromium salts, cobalt salts, halogens, hypochlorites, or combinations comprising at least one of the foregoing oxidizers. The preferred oxidizer is hydrogen peroxide. It is to be noted that the oxidizer is typically added to the polishing composition just prior to use and in these instances the oxidizer is contained in a separate package and mixed at the place of use. This is particularly useful for unstable oxidizers, such as, hydrogen peroxide.

Adjusting the amount of oxidizer, such as peroxide, can also control the metal interconnect removal rate. For example, increasing the peroxide concentration increases the copper removal rate. Excessive increases in oxidizer, however, provide an adverse impact upon polishing rate.

The barrier metal polishing composition includes an abrasive for "mechanical" removal of the barrier material. The abrasive is preferably a colloidal abrasive. Example abrasives include the following: inorganic oxide, metal boride, metal carbide, metal hydroxide, metal nitride, or a combination comprising at least one of the foregoing abrasives. Suitable inorganic oxides include, for example, silica (SiO₂), alumina (Al₂O₃), zirconia (ZrO₂), ceria (CeO₂), manganese oxide (MnO₂), and mixtures thereof. Alumina is available in many forms such as alpha-alumina, gamma-alumina, delta-alumina, and amorphous (non-crystalline) alumina. Other suitable examples of alumina are boehmite (AlO(OH)) particles and mixtures thereof. Modified forms of these inorganic oxides such as polymer-coated inorganic oxide particles may also be utilized if desired. Suitable metal carbides, boride and nitrides include, for example, silicon carbide, silicon nitride, silicon carbonitride (SiCN), boron carbide, tungsten carbide, zirconium carbide, aluminum boride, tantalum carbide, titanium carbide, and mixtures comprising at least one of the foregoing metal carbides, boride and nitrides. Diamond may also be utilized as an abrasive if desired. Alternative abrasives also include polymeric particles and coated polymeric particles. Most advantageously, the abrasive is selected from the group consisting of alumina, ceria and silica and mixtures thereof. Because colloidal silica erodes low k dielectrics at low rates, colloidal silica represents the preferred abrasive.

The abrasive has a concentration in the aqueous phase of the polishing composition of 1 to 50 weight percent. For abrasive-free solutions, a fixed abrasive pad assists with the removal of the barrier layer. Preferably, the abrasive concentration is 5 to 50 weight percent. And most preferably, the abrasive concentration is 5 to 40 weight percent. Typically, increasing abrasive concentration increases the removal rate of barrier materials; and it especially increases the removal rate of tantalum-containing barriers, such as tantalum carbide, tantalum nitride, and tantalum carbide-nitride. For example, if a semiconductor manufacturer desires an increased barrier rate, then increasing the abrasive content can increase the dielectric removal rate to the desired level. For example, an abrasive concentration of 20 to 40 weight percent can produce selective polishing solutions with high barrier removal rates.

The abrasive preferably has an average particle size of less than 250 nm for preventing excessive metal dishing and dielectric erosion. For purposes of this specification, particle size refers to the colloidal silica's average particle size. Most preferably, the silica has an average particle size of less than 150 nm to further reduce metal dishing and dielectric erosion. In particular, an average abrasive particle size less than 75 nm removes the barrier metal at an acceptable rate without excessive removal of the dielectric material. For example, the least dielectric erosion and metal dishing occur with a colloidal silica having an average particle size of 20 to 75 nm. Decreasing the size of the colloidal silica tends to improve the selectivity of the solution; but it also tends to decrease the barrier removal rate. In addition, the preferred colloidal silica may include additives, such as dispersants to improve the stability of the silica at acidic pH ranges. One such abrasive is colloidal silica that is available from AZ Electronic Materials France S.A.S., ofPuteaux, France.

Optionally, 0 to 10 weight percent copper complexing agent prevents precipitation of nonferrous metals. For example, the slurry may contains 0.01 to 5 weight percent copper complexing agent. Preferably, the copper complexing agent is an organic acid. Example copper complexing agents include the following: acetic acid, citric acid, ethyl acetoacetate, glycolic acid, lactic acid, malic acid, oxalic acid, saliclylic acid, sodium diethyl dithiocarbamate, succinic acid, tartaric acid, thioglycolic acid, glycine, alanine, aspartic acid, ethylene diamine, trimethyl diamine, malonic acid, gluteric acid, 3-hydroxybutyric acid, propionic acid, phthalic acid, isophthalic acid, 3-hydroxy salicylic acid, 3,5-dihydroxy salicylic acid, gallic acid, gluconic acid, pyrocatechol, pyrogallol, tannic acid, and salts thereof. Preferably, the copper complexing agent is selected from the group consisting of acetic acid, citric acid, ethyl acetoacetate, glycolic acid, lactic acid, malic acid, oxalic acid. Most preferably, the copper complexing agent is citric acid.

An addition of 0.01 to 10 total weight percent inhibitor decreases removal rate of copper interconnects and protects the copper from static etch. For purposes of this application, copper interconnect refers to interconnects formed with copper having incidental impurities or copper-base alloys. Adjusting the concentration of an inhibitor adjusts the copper interconnect removal rate by protecting the metal from static etch. Preferably the slurry contains 0.005 to 10 weight percent inhibitor. Most preferably, the solution contains 0.01 to 2 weight percent inhibitor. The inhibitor may consist of a mixture of inhibitors. Azole inhibitors are particularly effective for copper interconnects. Typical azole inhibitors include benzotriazole (BTA), mercaptobenzothiazole (MBT), tolytriazole and imidazole. BTA is a particularly effective inhibitor for copper interconnects and imidazole can increase copper removal rate.

The polishing composition can operate at acidic and basic pH levels. Advantageously, it has a pH of at least 8 and a balance water. Preferably, the pH is between 8 and 12 and most preferably between 9 and 11.5. In addition, the solution most preferably relies upon a balance of deionized water to limit incidental impurities. A source of hydroxy ions, such as ammonia, sodium hydroxide or potassium hydroxide adjusts the pH in the basic region. Most preferably, the source of hydroxy ions is potassium hydroxide.

Optionally, the slurry may contain leveling agents such as chlorides or in particular, ammonium chloride, buffers, dispersion agents and surfactants. For example, the slurry optionally contains 0.0001 to 0.1 weight percent ammonium chloride. Ammonium chloride provides an improvement in surface appearance and it can also facilitate copper removal by increasing the copper removal rate. In particular, as addition of 0.01 to 0.1 weight percent ammonium chloride can increase copper removal rate.

The polishing composition can also optionally include buffering agents such as various organic and inorganic bases or their salts with a pKa in the pH range of greater than 8 to 12. The polishing composition can further optionally include defoaming agents, such as non-ionic surfactants including esters, ethylene oxides, alcohols, ethoxylate, silicon compounds, fluorine compounds, ethers, glycosides and their derivatives. The defoaming agent can also be an amphoteric surfactant. The polishing composition may optionally contain biocides, such as Kordek^{™} MLX (9.5 - 9.9% methyl-4-isothiazolin-3-one, 89.1 - 89.5% water and ≤1.0% related reaction product) or Kathon^{™} ICP III containing active ingredients of 2-methyl-4-isothiazolin-3-one and 5-chloro-2-methyl-4-isothiazolin-3-one, each manufactured by Rohm and Haas Company, (Kathon and Kordek are trademarks of Rohm and Haas Company).

Preferably, the slurry polishes a semiconductor substrate by applying the slurry to a semiconductor substrate by placing 21 kPa or less downward force on a polishing pad. The downward force represents the force of the polishing pad against the semiconductor substrate. The polishing pad may have a circular shape, a belt shape or a web configuration. This low downward force is particularly useful for planarizing the semiconductor substrate to remove a barrier material from the semiconductor substrate. Most preferably, the polishing occurs with a downward force of less than 15 kPa.

The solution provides a tantalum nitride greater than the carbon-doped oxide rate as measured in Angstroms per minute or a tantalum nitride to carbon-doped oxide selectivity of at least 1 to 1, respectively, as measured in removal rate of Angstroms per minute with a microporous polyurethane polishing pad pressure measured normal to a wafer of less than 20.7 kPa. A particular polishing pad useful for determining selectivity is the Hi embossed Politex^{™} microporous polyurethane polishing pad. Advantageously, the solution provides a tantalum nitride to carbon-doped oxide selectivity of at least 1.5 to 1, respectively, as measured with a microporous polyurethane polishing pad pressure measured in Angstroms per minute normal to a wafer of less than 20.7 kPa; and most advantageously, this range is at least 2 to 1, respectively.

### Examples

A series of comparative slurries (A to G) and examples (1 to 11) mixed with a balance of deionized water are shown below in Table 1.

**Table 1**

| Slurry | BTA (wt%) | Silica (wt%) | H₃PO₄ (wt%) | PVP (10K) | Guanidine Hydrocloride | CA (wt%) | NH4CI (wt%) | Poly(methyl vinyl ether-alt-malic (wt%) | Poly(methyl vinyl ether) |
|---|---|---|---|---|---|---|---|---|---|
| A | 0.2 | 14 | 0.3 | | | 0.3 | 0.01 | | |
| B | 0.08 | 14 | 0.3 | 0.2 | | 0.3 | 0.01 | 0.03 | |
| C | 0.08 | 14 | 0.3 | 0.2 | | 0.3 | 0.01 | 0.010 | |
| D | 0.08 | 14 | 0.3 | 0.2 | | 0.3 | 0.01 | 0.30 | |
| E | 0.08 | 14 | 0.3 | 0.2 | | 0.3 | 0.01 | 0.90 | |
| F | 0.02 | 14 | 0.1 | 0.4 | | 0.3 | 0.01 | | |
| G | 0.02 | 14 | 0.1 | 0.4 | 0.5 | 0.3 | 0.01 | | |
| 1 | 0.08 | 14 | 0 | | | 0.3 | 0.01 | | 0.005 |
| 2 | 0.08 | 14 | 0.3 | | | 0.3 | 0.01 | | 0.010 |
| 3 | 0.08 | 14 | 0.3 | | | 0.3 | 0.01 | | 0.005 |
| 4 | 0.2 | 14 | 0.3 | | | 0.3 | 0.01 | | 0.005 |
| 5 | 0.02 | 30 | | | | | | | 0.01 |
| 6 | 0.02 | 30 | | | 0.1 | | | | 0.01 |
| 7 | 0.02 | 30 | | | 0.3 | | | | 0.01 |
| 8 | 0.02 | 30 | | | 0.5 | | | | 0.01 |
| 9 | 0.02 | 30 | | | 1 | | | | 0.01 |
| 10 | 0.02 | 30 | | | | | | | 0.005 |
| 11 | 0.02 | 30 | | | | | | | 0.003 |

| | | | | | | | | | |
|---|---|---|---|---|---|---|---|---|---|
| All samples included 0.4 wt% H₂O₂, 0.005 wt% Biocide at a pH of 10.5, CA = citric acid, BTA=benzotriazole, Biocide = Kordek^{™} MLX manufactured by Rohm and Haas Company (9.5 - 9.9% methyl-4-isothiazolin-3-one, 89.1 - 89.5% water and ≤1.0% related reaction product), PVP=polyvinyl pyrollidone, Silica = 1501-50, a 50 nm average diameter colloidal silica particle from AZ Electronic Materials France S.A.S., of Puteaux, France and Sigma-Aldrich Co. supplied the Poly(methyl vinyl ether-alt-malic acid) and Poly(methyl vinyl ether). | | | | | | | | | |

### Example 1

Polishing tests employed 200 mm sheet wafers of Coral^{™} carbon doped oxide (CDO) from Novellus Systems, Inc., TEOS dielectric, tantalum nitride, and electroplated copper. Topographical data arise from polishing sheet wafers with IC1010™ and embossed Politex^{™} polishing pads from Rohm and Haas Electronic Materials CMP Technologies.

A MIRRA^{™} rotary type polishing platform polished the sheet wafers. First step copper polishing used Eternal slurry EPL2360 with an IC1010™ polishing pad on platens 1 and 2. The pad conditioner was the Kinik AD3CG-181060 grid diamond conditioning disk. The polishing conditions for platens 1 were platen speed 93 rpm, carrier speed 21 rpm and downforce of 4 psi (27.6 kPa) and platen 2 platen Speed of 33 rpm, carrier speed 61 rpm and downforce of 3 psi (20.7 kPa). The polishing conditions for platen 3 were 1.5 psi (10.3 kPa) downforce, 93 rpm platen speed, 87 rpm carrier speed with a slurry flow rate of 200 ml/min. using Hi embossed Politex^{™} polishing pads.

Removal rates were calculated from the before and after polish film thickness. All optically transparent films were measured using a Tencor SM300 ellipsometric measuring device configured at 170 x 10⁻⁶ Ω for copper and 28,000 x 10⁻⁶ Ω for tantalum nitride. Wafer topography data was collected using a Dektak Veeco V200SL stylus profilometer. All the reported removal rates expressed in the specification are in units of Å/min.

**Table 2**

| Slurry | A | | B | | C | | D | | E | |
|---|---|---|---|---|---|---|---|---|---|---|
| Down force (psi/KPa) | Cu (RR) | CDO (RR) | Cu (RR) | CDO (RR) | Cu (RR) | CDO (RR) | Cu (RR) | CDO (RR) | Cu (RR) | CDO (RR) |
| 1.0/6.9 | 158 | 1216 | 191 | 444 | 188 | 630 | 202 | 735 | 205 | 581 |
| 1.5/10.3 | 227 | 1985 | 293 | 909 | 347 | 1214 | 567 | 1309 | 658 | 1095 |
| 2.0/13.8 | 325 | 2601 | 392 | 1047 | 646 | 1532 | 925 | 1728 | 886 | 1272 |
| 2.5/17.2 | 423 | 3195 | 522 | 1164 | 936 | 1772 | 1189 | 2019 | 1085 | 1448 |

The data of Table 2 illustrate that poly(methyl vinyl ether-alt-malic acid) has a moderate impact on carbon-doped oxide removal rates. In general, it decreases carbon-doped oxide removal rates with a significant increase in copper removal rate. This increase in copper removal rate provides a substantial decrease in the utility of the formulation.

**Table 3**

| Slurry | A | | 1 | | | 2 | | 3 | | 4 | |
|---|---|---|---|---|---|---|---|---|---|---|---|
| Down force (psi/KPa) | Cu (RR) | CDO (RR) | Cu (RR) | CDO (RR) | TaN (RR) | Cu (RR) | CDO (RR) | Cu (RR) | CDO (RR) | Cu (RR) | CDO (RR) |
| 1.0/6.9 | 158 | 1216 | 65 | 109 | | 121 | 38 | 140 | 42 | 65 | 48 |
| 1.5/10.3 | 227 | 1985 | 216 | 201 | 1014 | 288 | 129 | 545 | 167 | 133 | 185 |
| 2.0/13.8 | 325 | 2601 | 311 | 318 | | 729 | 278 | 812 | 313 | 216 | 387 |
| 2.5/17.2 | 423 | 3195 | 369 | 415 | | 952 | 391 | 1100 | 460 | 295 | 639 |

By referring to Tables 1 and 3, it becomes apparent that an addition of 50 ppm of Poly(methyl vinyl ether) can decrease the carbon-doped oxide removal rate from 1985 to 201 Å/min (slurries A , 1), while the Cu and TaN removal rates almost have no change. This decrease occurred in the presence of 14 weight percent silica-a concentration that typically results in excessive low k dielectric erosion.

**Table 4**

| Slurry | Avg TEOS (RR) | Avg. Cu (RR) | Avg. TaN (RR) | Avg. CDO (RR) | Poly(methyl vinyl ether) (wt%) | Guanadine hydrochloride (wt%) | Silica (wt%) |
|---|---|---|---|---|---|---|---|
| F | 679 | 499 | | 604 | | | 14 |
| 5 | 1332 | 816 | 1381 | 325 | 0.01 | | 30 |
| 6 | 1288 | 751 | 1393 | 448 | 0.01 | 0.1 | 30 |
| 7 | 1229 | 656 | 1383 | 547 | 0.01 | 0.3 | 30 |
| 8 | 1154 | 509 | 1335 | 622 | 0.01 | 0.5 | 30 |
| 9 | 1008 | 184 | 1289 | 546 | 0.01 | 1 | 30 |
| 10 | 1268 | 788 | 1370 | 795 | 0.005 | | 30 |
| 11 | 1282 | 790 | 1370 | 1179 | 0.003 | | 30 |
| G | 670 | 705 | 834 | 689 | | 0.5 | 14 |

The above Examples illustrate that the polishing slurry can operate with high silica concentrations for rapid TaN removal and acceptable copper and carbon-doped oxide removal rates. In particular, slurries 5 to 11 provided effective decreases in carbon-doped oxide removal rates in the presence of 30 weight percent silica-a concentration that far exceeds concentrations that typically erode low k dielectric at unacceptable rates.

## Claims

1. An aqueous slurry useful for chemical mechanical polishing a semiconductor substrate having copper interconnects comprising by weight percent, 0 to 25 oxidizing agent, 1 to 50 abrasive particles, 0.001 to 10 inhibitor for decreasing static etch of the copper interconnects, 0.001 to 5 poly (methyl vinyl ether) having a formula as follows: 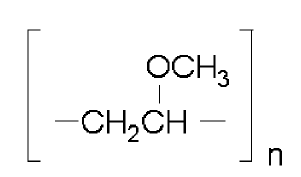 and the poly (methyl vinyl ether) is water soluble and n has a value of at least 5, 0 to 10 copper complexing agent formed during polishing and balance water.

2. The aqueous slurry of claim 1 wherein the slurry includes 0.01 to 5 weight percent of at least one selected from formamidine, formamidine derivatives, formamidine salts, guanidine, guanidine derivatives and guanidine salts and mixture thereof.

3. The aqueous slurry of claim 1 wherein the slurry includes 5 to 50 weight percent colloidal silica abrasive particles.

4. An aqueous slurry useful for chemical mechanical polishing a semiconductor substrate having copper interconnects comprising by weight percent, 0 to 20 oxidizing agent, 5 to 50 abrasive particles, 0.005 to 10 inhibitor for decreasing static etch of the copper interconnects, 0.005 to 5 poly (methyl vinyl ether) having a formula as follows: 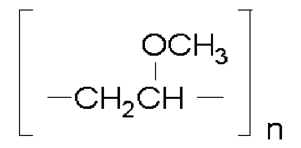 and the poly (methyl vinyl ether) is water soluble and n has a value of at least 10, 0 to 10 copper complexing agent formed during polishing and balance water; and the aqueous slurry having a pH of at least 8.

5. The aqueous slurry of claim 4 wherein the slurry includes 0.01 to 3 weight percent of at least one selected from formamidine, formamidine derivatives, formamidine salts, guanidine, guanidine derivatives and guanidine salts and mixture thereof.

6. The aqueous slurry of claim 4 wherein the slurry includes 20 to 40 weight percent silica abrasive particles.

7. The aqueous slurry of claim 4 wherein the slurry includes 0.0001 to 1 weight percent ammonium chloride.

8. The aqueous slurry of claim 4 wherein the slurry includes 0.01 to 5 weight percent copper complexing agent.

9. A method of polishing a semiconductor substrate, the semiconductor substrate having a barrier layer, a TEOS layer and a low k dielectric layer, the method including the steps of:
introducing polishing slurry onto a polishing pad, the polishing slurry having the composition comprising by weight percent, 0 to 25 oxidizing agent, 1 to 50 abrasive particles, 0.001 to 10 inhibitor for decreasing static etch of the copper interconnects, 0.001 to 5 poly (methyl vinyl ether) having a formula as follows: 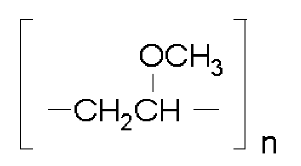 and the poly (methyl vinyl ether) is water soluble and n has a value of at least 5, 0 to 10 copper complexing agent formed during polishing and balance water;
pressing the semiconductor substrate against the polishing pad; and
creating motion between the polishing pad and the semiconductor substrate to remove the barrier layer with a selectivity to a carbon-doped oxide layer rate of at least 1 to 1 for removal rate measured in Angstroms per minute.

10. The method of claim 9 wherein the process removes a tantalum-containing or titanium-containing barrier layer at a rate greater than a carbon-doped low k dielectric layer as measured in Å/min.
